# FASCICULE DE BREVET EUROPEEN

(11) **EP 3 571 760 B1**
(45) Date de publication et mention de la délivrance du brevet: **18.10.2023**
(21) Numéro de dépôt: 18700357.9
(22) Date de dépôt: 16.01.2018
(51) Int. Cl.: H02P 9/12, H02H 7/00, H02M 7/538, H02K 11/05

(54) **DISPOSITIF ÉLECTRONIQUE, NOTAMMENT RÉGULATEUR D'ALTERNATEUR, ET PROCÉDÉ DE RÉGULATION D'UN TEL DISPOSITIF**
ELEKTRONISCHE VORRICHTUNG, INSBESONDERE EIN LICHTMASCHINENREGLER, UND VERFAHREN ZUR REGELUNG SOLCH EINER VORRICHTUNG
ELECTRONIC DEVICE, IN PARTICULAR ALTERNATOR REGULATOR, AND REGULATION METHOD OF SUCH A DEVICE

(30) Priorité: 20.01.2017 FR 1750486
(43) Date de publication de la demande: 27.11.2019
(73) Titulaire: Moteurs Leroy-Somer, 16915 Angouleme Cedex 9 (FR)
(72) Inventeur: MOSER, Samuel, 16160 Gond Pontouvre (FR); FRATANI, Jérémy, 16600 Magnac sur Touvre (FR); MORISSEAU, Vincent, 16110 La Rochefoucauld (FR); PAILLOU, Jean-François, 45000 Orleans (FR)
(74) Mandataire: Cabinet Nony
(86) Numéro de dépôt international: PCT/EP2018/050928
(87) Numéro de publication internationale: WO 2018/134171

(56) Documents cités:
- EP-A1- 2 747 270
- DE-A1-102008 037 064
- US-A1- 2014 077 745
- D A PAYNTER ET AL: "SESSION IV: Power and Control 4.5: Redundancy Techniques in Reliable Power Supply Design", UNIVERSITY MUSEUM (UNIVERSITY OF PENNSYLVANIA), vol. 3, 1 janvier 1961 (1961-01-01), pages 0-530, XP055457652,

## Description

La présente invention concerne les dispositifs électroniques tels que variateurs ou régulateurs, comportant un étage de puissance.

### Etat de la technique

Les variateurs ou régulateurs sont des dispositifs utilisés en liaison avec des moteurs ou alternateurs industriels pour contrôler la vitesse ou la tension de ceux-ci.

Ces dispositifs comprennent classiquement des composants de puissance, tels que des IGBT ou MOSFET par exemple, montés sur radiateur, et des condensateurs électrochimiques assez volumineux.

La tendance est de chercher à réduire leur encombrement.

Il a déjà été proposé de nombreuses solutions à cet effet.

La demande US 2014/0198455 divulgue un variateur de vitesse comportant des composants de puissance montés sur une carte de circuit imprimé, et des condensateurs disposés à 90° de cette carte.

La demande US 2010/0202109 décrit un dispositif dans lequel les condensateurs sont disposés à côté du radiateur, et traversent des ouvertures d'un guide d'air de refroidissement.

Le brevet US 8810178 divulgue un variateur de vitesse comportant un boîtier pourvu d'ouvertures traversées par les condensateurs. Un joint d'étanchéité sous la forme d'une feuille perforée est disposé sous les ouvertures du boîtier. Un capot amovible vient recouvrir les extrémités des condensateurs qui dépassent des ouvertures.

Le modèle d'utilité CN205430848 U décrit un variateur dont le radiateur porte, via des entretoises, une carte de circuit imprimé sur laquelle sont soudés les condensateurs. Le radiateur présente une découpe dans laquelle s'étendent les condensateurs.

La demande US 2014/077745 décrit un dispositif de commande d'entraînement d'un moteur comportant au moins deux onduleurs et un dispositif de commande permettant de passer d'un onduleur défectueux à un onduleur non défectueux.

La demande DE 102008037064 décrit un dispositif de commutation connectée à deux sources d'énergie électrique.

La demande EP 2747270 décrit un montage comportant deux transistors en parallèle commandés simultanément pour produire une tension alternative afin d'alimenter une charge inductive.

DA PAYNTER et al : « SESSION IV : Power adn Control 4.5 : Redundancy Techniques in Reliable Power Supply Design », University Museum (University of Pennsylvania), vol.3, 1 janvier 1961 (1961-01-01), pages 0-530, XP 055457652, décrit des méthodes classiques de redondance dans les circuits électroniques.

Il existe un besoin pour perfectionner encore les dispositifs électroniques tels que les variateurs ou régulateurs, afin notamment de les rendre encore plus compacts, tout en gardant une fiabilité élevée et un coût de fabrication compatible avec les exigences industrielles pour ce type de produit.

Par ailleurs, afin de fournir un courant d'excitation aux alternateurs à rotor bobiné, les régulateurs de tension utilisent classiquement un pont de puissance constitué à minima d'un IGBT et d'une diode de roue libre. Afin de permettre la désexcitation rapide sous certaines conditions, un demi pont en H peut être utilisé afin d'inverser la tension aux bornes de l'inducteur de l'alternateur. Certaines conditions extrêmes de fonctionnement peuvent entraîner la casse d'un de ces composants de puissance, comme par exemple une surexcitation ou une utilisation sous température ambiante excessive. Cette casse rend le dispositif totalement inopérant et la surexcitation ou sous excitation générée peut, dans certaines applications telles que l'extraction des fumées de tunnel, la fourniture d'électricité à un hôpital, ou l'alimentation des pompes de refroidissement des réacteurs nucléaires, s'avérer critique.

Il y a par conséquent un intérêt pour améliorer encore la fiabilité des régulateurs d'alternateur.

Il existe encore un besoin pour faciliter la fixation de l'appareil sur un support.

L'invention vise à répondre à tout ou partie de ces besoins.

### Résumé

L'application a pour objet un dispositif électronique, encore appelé appareil, notamment variateur de vitesse ou régulateur d'alternateur, comportant au moins un composant de puissance monté sur un dissipateur thermique, encore appelé radiateur, et une pluralité de condensateurs s'étendant à travers au moins une ouverture du dissipateur.

De préférence, le dispositif comporte un renfoncement dans lequel est reçu un joint d'étanchéité en feuille s'appliquant d'une part sur une face intérieure du dissipateur et d'autre part sur une face intérieure en regard d'un boîtier rapporté sur le dissipateur, les faces intérieures du dissipateur et du boîtier venant en contact.

Cet aspect de l'application contribue à la compacité de l'appareil tout en assurant un refroidissement efficace du composant de puissance. Le joint permet d'éviter l'entrée d'eau dans l'appareil, et le fait qu'il soit reçu dans un renfoncement permet de ménager des surfaces de contact entre le dissipateur et le boîtier pour favoriser un transfert thermique du dissipateur vers le boîtier.

Le renfoncement est de préférence réalisé dans le boîtier. Ce dernier peut être réalisé en deux parties assemblées. Le boîtier est par exemple métallique ou en matière plastique.

L'un au moins du boîtier et du dissipateur peut comporter des picots de centrage et le joint présenter des trous correspondants dans lesquels sont engagés les picots de centrage. On limite ainsi le risque d'un mauvais positionnement du joint dans le renfoncement précité.

Le joint peut comporter une ouverture dans laquelle est disposée une entretoise métallique s'étendant entre le dissipateur et un composant de puissance annexe, notamment un pont de diodes.

De préférence, le composant de puissance s'applique sur le dissipateur au travers d'une ouverture du boîtier. Ainsi, on peut améliorer la qualité du contact thermique entre le composant de puissance et le dissipateur.

Le composant de puissance peut être soudé sur une platine de circuit imprimé d'une carte de puissance, cette platine présentant des fentes pour former des languettes flexibles sur lesquelles s'étendant des pistes conductrices sur lesquelles les broches du composant de puissance sont soudées. On réalise ainsi un montage capable d'une certaine déformation élastique, ce qui facilite le bon positionnement du composant de puissance sur le dissipateur et limite le risque de casse du module par effort sur les broches de celui-ci.

L'appareil peut comporter plusieurs, par exemple cinq, condensateurs disposés en U, la concavité du U étant orientée vers le composant de puissance. Cela permet de gagner encore en compacité.

Le composant de puissance peut comporter une pluralité de transistors de puissance, notamment d'IGBT ou de MOSFET.

L'application a encore pour objet, selon un deuxième aspect indépendant du premier mais qui peut avantageusement se combiner avec celui-ci, un dispositif électronique, notamment variateur de vitesse ou régulateur d'alternateur, comportant un dissipateur thermique et une carte de puissance comportant une platine de circuit imprimé, logée dans un boîtier.

De préférence, le dispositif comporte une pièce fixée d'une part au dissipateur et fixée d'autre part à la platine et venant au contact d'au moins une piste conductrice de la carte de puissance, de façon à assurer un contact électrique entre le dissipateur et ladite piste, cette pièce ayant une face accessible depuis l'extérieur du dispositif pour la fixation d'une cosse reliée à un câble de masse et/ou de terre.

Ce montage permet d'établir la connexion à la fois électrique et mécanique entre le dissipateur et la carte de puissance, d'une façon fiable et contribuant à la compacité du dispositif, puisque la même pièce peut également servir pour une connexion externe.

La pièce peut avoir un trou pour recevoir une vis de fixation de ladite cosse.

Le dispositif peut comporter un boîtier ayant une ouverture pour le passage de la pièce. Ce boîtier peut comporter deux parties assemblées, l'ouverture étant réalisée dans une partie du boîtier en contact avec le dissipateur. La carte de puissance peut être fixée sur le boîtier, notamment sur des fûts de réception de vis de celui-ci.

Le dispositif peut comporter une platine de circuit imprimé entre celle de la carte de puissance et le dissipateur. Cette platine peut porter des connecteurs et/ou borniers. Le fait de disposer une telle platine permet d'utiliser l'espace laissé libre sous la carte de puissance et d'améliorer encore la compacité du dispositif.

Le dispositif comporte de préférence des connecteurs et/ou borniers sur trois côtés ainsi que sur sa face frontale.

L'application a encore pour objet, selon un troisième de ses aspects, indépendant des deux aspects ci-dessus mais pouvant avantageusement se combiner à l'un quelconque de ceux-ci, un dispositif électronique, notamment variateur de vitesse ou régulateur d'alternateur, comportant un boîtier ayant en façade un logement de réception d'un module annexe, une trappe de fermeture de ce logement, et un circuit électronique comportant une carte d'interface définissant un logement de réception d'une carte mémoire, débouchant dans le logement de réception du module annexe.

L'application, selon cet aspect, permet d'interdire l'accès à la carte mémoire tant que la trappe est en place, ce qui est la situation normale, la trappe n'étant destinée à être enlevée que pour une opération de maintenance. Le dispositif peut ainsi avantageusement comporter une étiquette d'inviolabilité recouvrant au moins partiellement la trappe. De plus, le fait de disposer le logement de réception de la carte mémoire à cet emplacement permet de profiter du dégagement offert par le logement de réception du module annexe pour la mise en place et le retrait de la carte, ce qui contribue à la compacité du dispositif et à son ergonomie.

La carte d'interface comporte de préférence un écran et des boutons accessibles au travers de trous du boîtier.

Le logement de carte mémoire débouche de préférence dans un renfoncement du boîtier destiné à recevoir une patte de verrouillage de la trappe. Cette patte de verrouillage comporte de préférence un trou de passage d'une vis.

Diverses informations peuvent être enregistrées dans la carte mémoire. De préférence, le dispositif est configuré pour enregistrer un historique de fonctionnement du dispositif sur la carte mémoire.

De préférence, le dispositif comporte au moins un connecteur en façade, notamment de type RJ45 ou USB. Ce connecteur peut être utilisé pour la mise à jour du dispositif, sans avoir à procéder à aucun démontage.

Ce ou ces connecteurs de façade peuvent être portés par des extensions d'une platine de circuit imprimé de la carte d'interface, s'étendant de part et d'autre du renfoncement précité destiné à recevoir la patte de verrouillage de la trappe. Cela permet de gagner encore en compacité.

Le boîtier peut comporter des parties inférieure et supérieure assemblées, le logement étant réalisé dans la partie supérieure de boîtier. La partie inférieure est avantageusement fixée à un dissipateur thermique, le boîtier logeant une carte de puissance et une carte de contrôle superposées, la carte d'interface étant disposée au-dessus de la carte de contrôle, le logement s'étendant sous la carte d'interface quand l'appareil est disposé verticalement avec l'ouverture du logement de réception de la carte mémoire orienté vers le bas. Une telle disposition s'avère ergonomique, compacte et facile à assembler et à maintenir.

L'invention a pour objet, selon un autre de ses aspects, qui est indépendant des précédents mais qui peut avantageusement se combiner à ces derniers, un dispositif électronique, tel que défini dans la revendication indépendante 1

Un tel aspect de l'invention procure une fiabilité accrue au fonctionnement du dispositif.

Le circuit de commande est avantageusement agencé pour, en cas de défaillance d'un transistor de la première paire l'amenant à rester en circuit ouvert, envoyer le signal de commande pulsé sur l'autre transistor de cette paire.

Le dispositif comporte une deuxième paire de transistors reliés en parallèle entre une deuxième sortie à relier à la charge et la borne opposée du bus continu, au moins une diode reliant la deuxième sortie à la borne du bus continu, l'un au moins des transistors de la deuxième paire étant piloté par le circuit de commande de façon à être passant pendant le fonctionnement normal de l'appareil.

De préférence, l'autre transistor de la deuxième paire est commandé par le circuit de commande de façon à être bloqué pendant le fonctionnement normal.

Le circuit de commande est de préférence agencé pour, en cas de défaillance de l'un des transistors de la deuxième paire l'amenant à rester en circuit ouvert, piloter l'autre transistor de cette paire pour le saturer.

Le circuit de commande est de préférence agencé pour, en cas de défaillance d'un transistor de la première paire l'amenant à rester en court-circuit, piloter le second transistor de cette paire pour le saturer, maintenir un transistor de l'autre paire à l'état bloqué et envoyer le signal de commande pulsé à l'autre transistor de cette deuxième paire.

Le dispositif peut comporter deux diodes de roue libre en parallèle.

Le dispositif peut également comporter deux diodes en parallèle reliant la deuxième sortie à la borne du bus continu.

Le dispositif est avantageusement réalisé de façon à pouvoir fonctionner en mode d'inversion de la tension aux bornes de la charge, encore appelé « forcing négatif », lorsque le courant dans la charge doit être rapidement annulé pour les besoins de la régulation, mode dans lequel les transistors de la première paire sont pilotés bloqués et les deux transistors de la deuxième paire également.

Le signal de commande pulsé est de préférence un signal de commande PWM (Pulse Width Modulation).

Les transistors de la première paire peuvent appartenir à un module de puissance comprenant trois branches en parallèle, chaque branche comprenant deux transistors en série, et un septième transistor en série avec une diode, l'ensemble formé par ce transistor en série avec la diode étant relié en parallèle avec les trois branches, les transistors de la première paire étant pris chacun au sein d'une branche respective. L'un des transistors de la deuxième paire peut être pris au sein de la branche restante et l'autre transistor être constitué par le transistor qui est en série avec la diode.

Les transistors peuvent être des IGBT ou des MOSFET, ou encore peuvent être remplacés par des thyristors ou des transistors bipolaires. De préférence, les composants utilisés pour réaliser le pont sont des IGBT.

L'invention a encore pour objet un procédé de régulation d'un altenateur tel que défini dans la revendication indépendante 12.

L'application a encore pour objet, selon un cinquième de ses aspects, qui peut se combiner aux précédents, un ensemble comportant :
- Un dispositif électronique, notamment variateur de vitesse ou régulateur d'alternateur, comportant un boîtier muni à l'arrière d'un dissipateur thermique réalisé à partir d'un profilé métallique, pour le refroidissement d'au moins un composant de puissance,
- un premier ensemble d'éléments de fixation du dispositif sur un support, comportant chacun au moins une languette à engager dans le profilé en la faisant coulisser dans celui-ci, et une patte de fixation pourvue d'au moins un trou de passage de vis,
- un deuxième ensemble d'éléments de fixation du dispositif sur un support, comportant chacun au moins une languette à engager dans le profilé en la faisant coulisser dans celui-ci, et une patte de fixation pourvue d'au moins un trou de passage de vis,
les éléments étant de formes différentes.

L'application selon cet aspect facilite le montage du dispositif dans différentes configurations d'espace disponible, en permettant de choisir les éléments les mieux adaptés.

Les éléments du premier et/ou du deuxième ensemble peuvent comporter chacun deux languettes.

Les éléments du premier ensemble peuvent comporter au moins un trou disposé sensiblement dans le prolongement d'une languette.

Les éléments du deuxième ensemble peuvent comporter chacun au moins un trou disposé latéralement sur le côté du dissipateur.

Les éléments peuvent venir chacun axialement en butée contre une extrémité longitudinale du dissipateur.

Les pattes peuvent être, lorsque les éléments sont montés sur le dissipateur, situées dans un plan décalé de celui des languettes.

Le profilé peut comporter des glissières de réception des languettes formées chacune de deux ailettes munies de retours dirigés l'un vers l'autre et d'une ailette intermédiaire de moindre hauteur, munie d'un patin sur son bord libre.

Les languettes peuvent présenter des trous taraudés pour recevoir des vis de serrage des patins précités, venant en appui sur ces derniers lorsque serrées.

### Description détaillée

La présente invention pourra être mieux comprise à la lecture de la description détaillée qui va suivre, d'exemples de mise en oeuvre non limitatifs de celle-ci, et à l'examen du dessin annexé, sur lequel :
- La figure 1 représente de façon schématique en perspective un exemple d'appareil selon l'application,
- la figure 2 représente l'appareil vu de dessous,
- la figure 3 est une vue analogue à la figure 2 d'une variante de réalisation,
- la figure 4 représente l'appareil avec le radiateur enlevé,
- la figure 5 est une vue analogue à la figure 4 avec le joint de sortie des condensateurs enlevé,
- la figure 6 représente isolément, en perspective, la partie inférieure du boîtier,
- la figure 7 représente en vue de face l'appareil,
- la figure 8 est une vue analogue à la figure 7 après enlèvement de la trappe d'accès au module additionnel,
- la figure 9 représente isolément la partie supérieure du boîtier,
- la figure 10A représente l'appareil avec la partie supérieure du boîtier enlevée,
- la figure 10B est une coupe transversale de l'appareil,
- la figure 10C représente la carte de puissance du côté de sa face opposée au radiateur,
- la figure 10D est une coupe transversale schématique et partielle de l'appareil,
- la figure 10E représente l'appareil avec la platine de la carte de puissance enlevée,
- la figure 11 représente un détail de la figure 10A,
- la figure 12 est une vue éclatée faisant apparaître certains composants constitutifs de l'appareil,
- la figure 13 est un schéma du pont de puissance de l'appareil, et
- la figure 14 illustre la correspondance entre les transistors du pont et le module de puissance dans un exemple de réalisation.

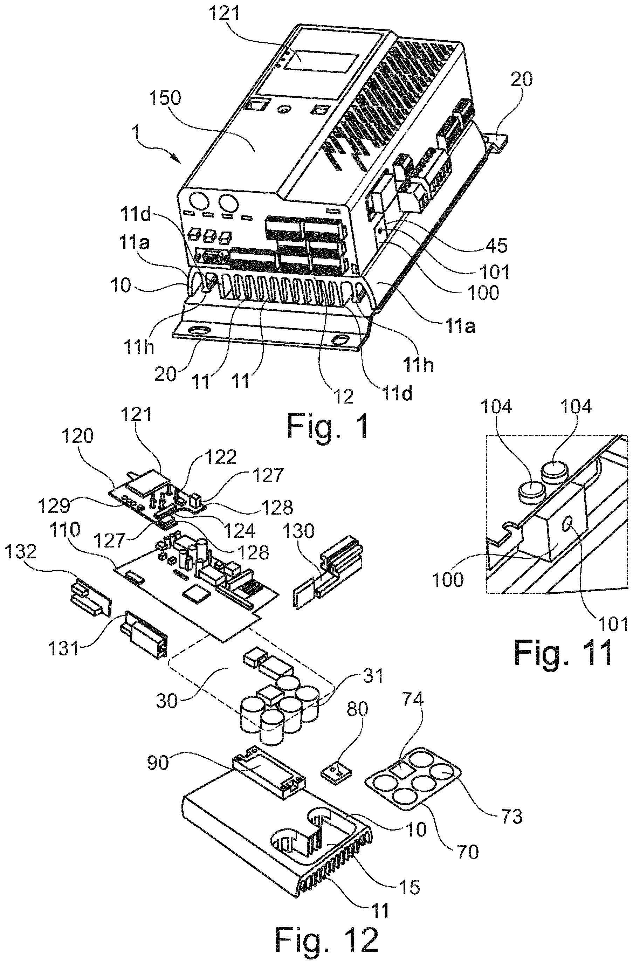

L'appareil 1 représenté sur les figures 1 à 12 est un régulateur d'alternateur, mais l'invention n'est pas limitée à un régulateur d'alternateur et s'applique également à un variateur de vitesse ou à un onduleur, entre autres appareils mettant en oeuvre des composants de puissance et des condensateurs électrochimiques relativement encombrants.

L'appareil 1 comporte à l'arrière un dissipateur thermique 10, encore appelé radiateur, qui présente des ailettes parallèles 11 se raccordant à leur base à une paroi 12. Le radiateur 10 est classiquement réalisé en aluminium ou alliage d'aluminium à l'aide d'une filière par exemple.

L'appareil 1 peut être dépourvu de ventilateur, le refroidissement du radiateur 10 s'effectuant par convection naturelle uniquement.

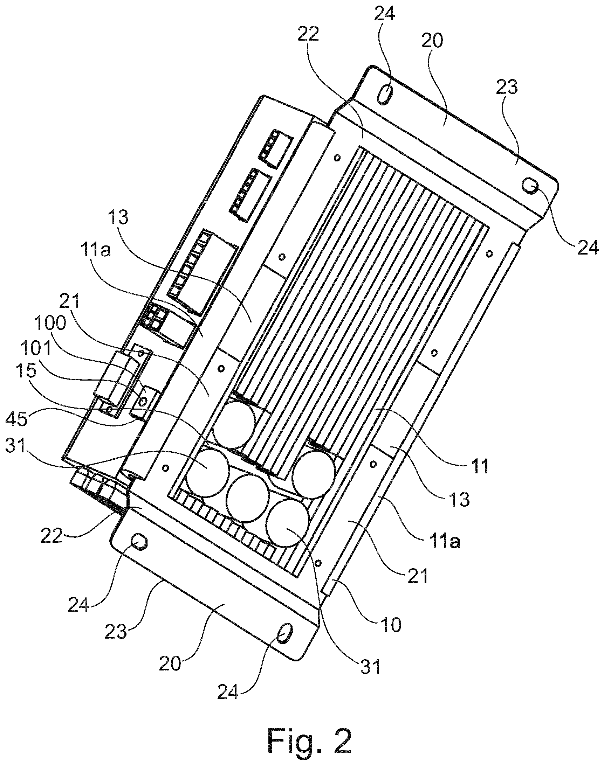

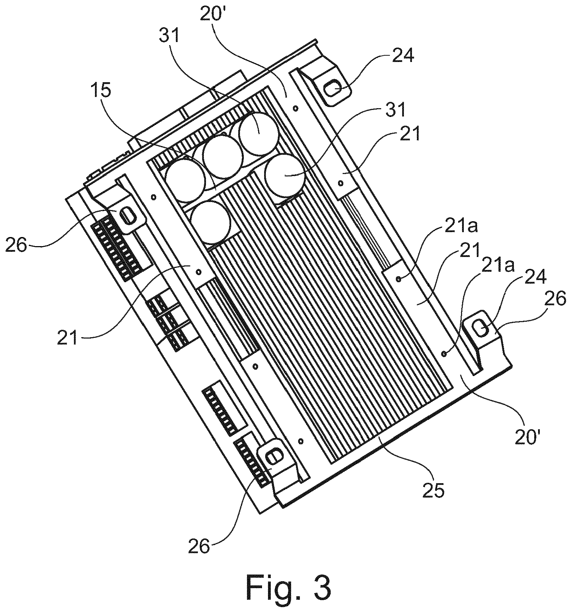

Le radiateur 10 définit deux glissières longitudinales 13 s'étendant chacune le long de l'ailette 11a la plus extérieure, destinées à recevoir des éléments de fixation 20 ou 20' de formes différentes, représentés respectivement sur les figures 2 et 3.

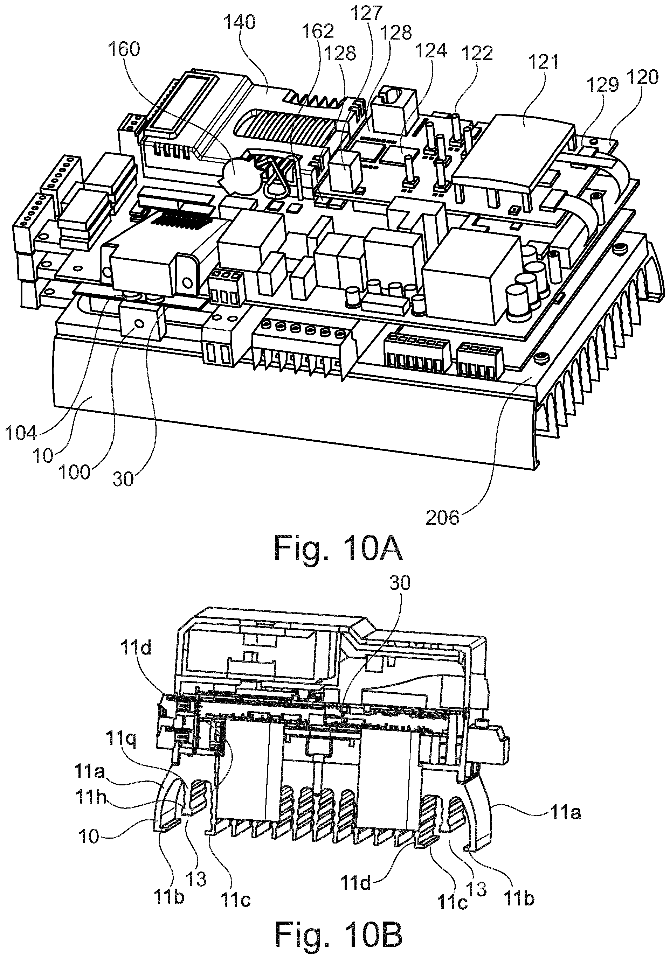

L'ailette 11a présente sur son bord libre un retour 11b vers l'intérieur. Ce retour 11b fait face à un retour 11c dirigé vers l'ailette 11a, porté par une ailette 11d du radiateur 10, comme on peut le voir sur la figure 10B. Les retours 11b et 11c sont coplanaires. Une ailette intermédiaire 11g, moins haute, s'étend entre les ailettes 11a et 11d. Cette ailette 11g est pourvue sur son bord libre d'un patin 11h nervuré.

### Fixation de l'appareil

Les éléments 20 et 20' servent à la fixation de l'appareil sur une surface de réception.

La possibilité d'utiliser des éléments 20 et 20' de formes différentes accroît le nombre de configurations de pose de l'appareil.

Chaque élément 20 comporte deux languettes 21 engagées chacune dans une glissière 13, ces languettes 21 étant réunies par un bandeau 22 doublement coudé de façon à définir une patte de fixation 23 parallèle au bandeau 22, ou perpendiculaire aux languettes 21, mais située à une hauteur différente.

Les pattes 23 sont traversées chacune par deux trous 24.

Dans la variante de la figure 3, le bandeau 22 est remplacé par une cornière 25 pourvue de deux pattes de fixation 26 dirigées vers l'appareil 1, alors que dans l'exemple de la figure 2 les pattes 23 sont dirigées vers l'extérieur et non vers l'appareil 1. Chaque patte 26 est pourvue d'un trou 24.

Chaque languette 21 engagée dans une glissière 13 vient en appui par une face contre les retours 11b et 11c

L'utilisateur désirant fixer l'appareil 1 choisit les éléments de fixation 20 ou 20' adaptés au cas d'espèce, les engage dans les glissières 23. Une ou plusieurs vis, traversant les éléments 20 ou 20' dans les trous taraudés 21a prévus à cet effet, viennent en pression sur le patin nervuré 11h pour maintenir l'élément 20 ou 20' en position dans les glissières 13, puis procède à la fixation de l'appareil 1 grâce à des vis engagées dans les trous 24 par exemple.

### Montage des condensateurs

L'appareil 1 comporte plusieurs cartes électroniques dont une carte 30 dite de puissance qui porte des condensateurs électrochimiques 31 de bus continu, relativement encombrants, par exemple de capacité supérieure ou égale à 200µF sous une tension d'isolation supérieure ou égale à 250 VDC, notamment 400 VDC

Ces condensateurs 31 s'étendent vers l'arrière dans une ouverture 15 du radiateur 10. Dans l'exemple considéré, les condensateurs 31 sont au nombre de cinq, et l'ouverture 15 présente la forme générale d'un U, dont la concavité est tournée vers l'intérieur, comme on peut le voir sur les figures 2 ou 3 notamment.

Dans l'exemple considéré, la hauteur des ailettes 11 est suffisante pour que les condensateurs 31 ne dépassent pas du radiateur 10 vers l'arrière; ainsi, les condensateurs 31 restent relativement protégés des chocs par les ailettes 11.

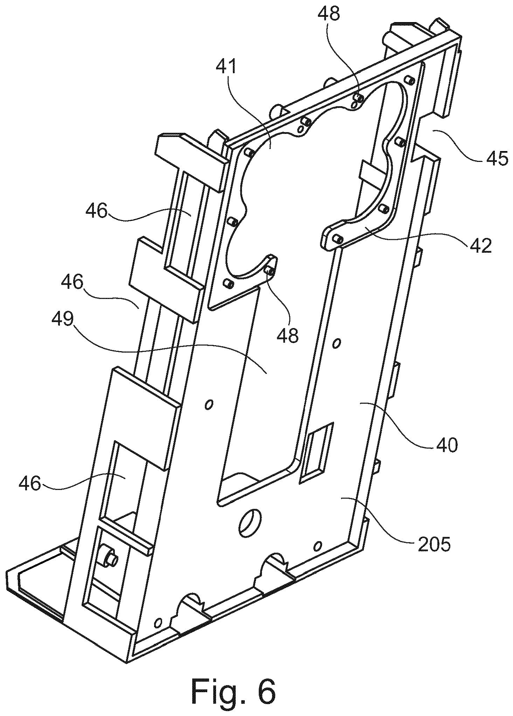

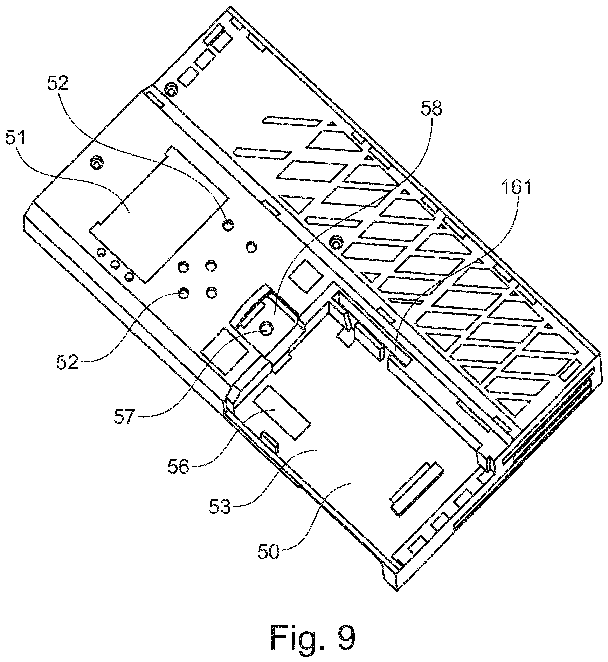

L'appareil 1 comporte un boîtier comprenant une partie inférieure 40 et une partie supérieure 50, représentées sur les figures 6 et 9 respectivement.

Ces parties 40 et 50 sont de préférence réalisées en plastique, de préférence renforcée, , mais en variante sont réalisées en métal, par exemple de l'aluminium,.

La partie inférieure 40 est réalisée avec une ouverture 41 pour le passage des condensateurs 31.

Un renfoncement 42 est formé sur la face arrière de cette partie inférieure autour de l'ouverture 41 pour accueillir un joint 70 formé d'une feuille d'un matériau élastomère pourvue de trous pour le passage de chacun des condensateurs 31. Ainsi, le joint 70 s'applique à la fois sur la périphérie du corps cylindrique de chaque condensateur 31 et sur les faces en regard de la partie inférieure 40 de boîtier et du radiateur 10.

On garantit ainsi une sortie étanche des condensateurs 31 et l'on évite qu'en cas de condensation d'eau sur les ailettes 11 du radiateur, celle-ci ne gagne par ruissellement l'intérieur du boîtier.

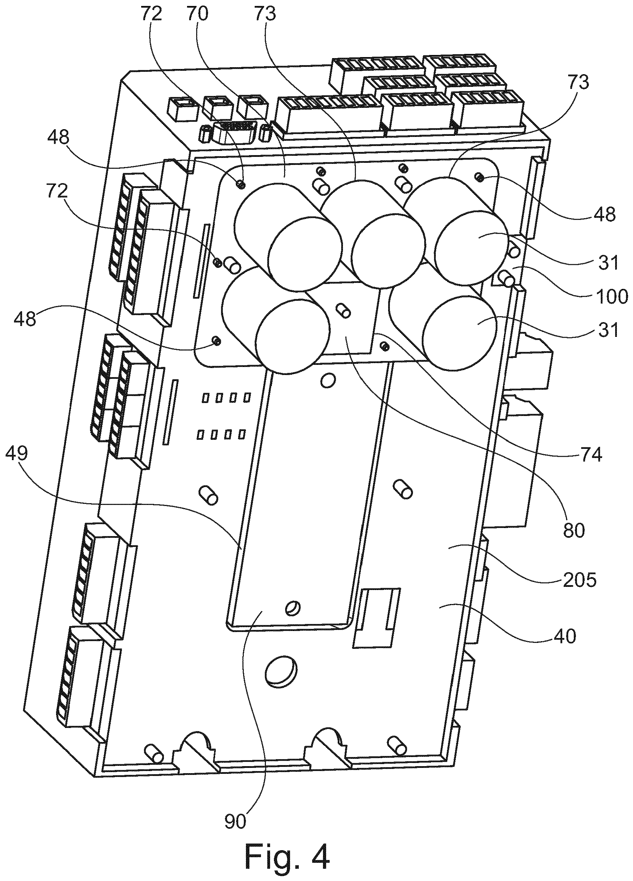

Dans l'exemple considéré, la partie inférieure de boîtier 40 comporte des picots de positionnement 48 et le joint 70 des trous 72 correspondants (visibles sur la figure 4).

Outre des ouvertures 73 pour le passage des condensateurs 31, le joint 70 comporte dans l'exemple illustré une fenêtre 74 pour le passage d'une entretoise 80 fixée contre le radiateur 10, dont l'épaisseur est légèrement supérieure à celle du joint 70.

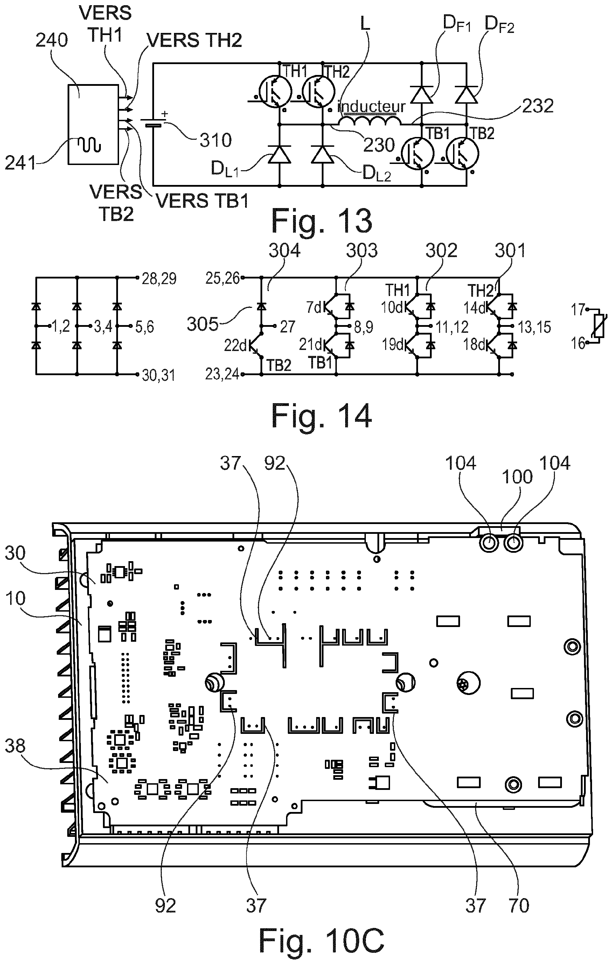

La partie inférieure 40 du boîtier présente une ouverture 49 pour la mise en place contre le radiateur 10 d'un module de puissance 90. Cette ouverture 49 communique avec l'ouverture 41, ce qui permet la fixation sur l'entretoise 80 d'un composant à refroidir, par exemple un pont de diodes ou tout autre composant nécessitant une dissipation thermique. Comme on peut le voir sur la figure 10C, qui représente la carte de puissance 30 avec la partie inférieure 40 du boîtier enlevée, le module 90 est soudé sur la platine 38 de circuit imprimé de la carte de puissance 30 à l'aide de broches 92. Ces dernières sont reliées à des pistes conductrices de la platine 38. Au niveau de la zone de soudure des broches 92 à la platine 38, des fentes 37 sont réalisées afin de conférer de l'élasticité à la fixation du module 90 sur la platine 38. Ainsi, ce dernier peut être plaqué contre le radiateur 10 par sa face opposée à la platine même en cas de mauvais parallélisme entre la platine 38 et la face intérieure en regard du radiateur 10. Les fentes 37 limitent l'effort sur les broches du module, crées par les tolérances d'assemblage du produit.

L'appareil 1 comporte une carte de contrôle 110 qui se superpose à la carte de puissance et qui comporte un ou plusieurs microcontrôleurs ou circuits analogiques pour gérer le fonctionnement de l'appareil 1.

Une carte d'interface HMI 120 est disposée au-dessus de la carte de contrôle 110 et comporte un afficheur 121 ainsi que plusieurs boutons de commande 122 portés par une platine 129.

L'appareil 1 comporte également des cartes 130 à 133 qui portent des connecteurs et borniers accessibles depuis les faces latérales et inférieure du boîtier.

Ces cartes 130 à 133 sont orientées perpendiculairement aux cartes de puissance 30 et de contrôle 110. La partie inférieure 40 de boîtier est réalisée avec des ouvertures 46 pour la sortie des connecteurs et borniers.

L'appareil 1 comporte également une carte 190 qui porte des borniers et connecteurs, et qui se situe du côté de l'appareil 1 opposé à la carte 130.

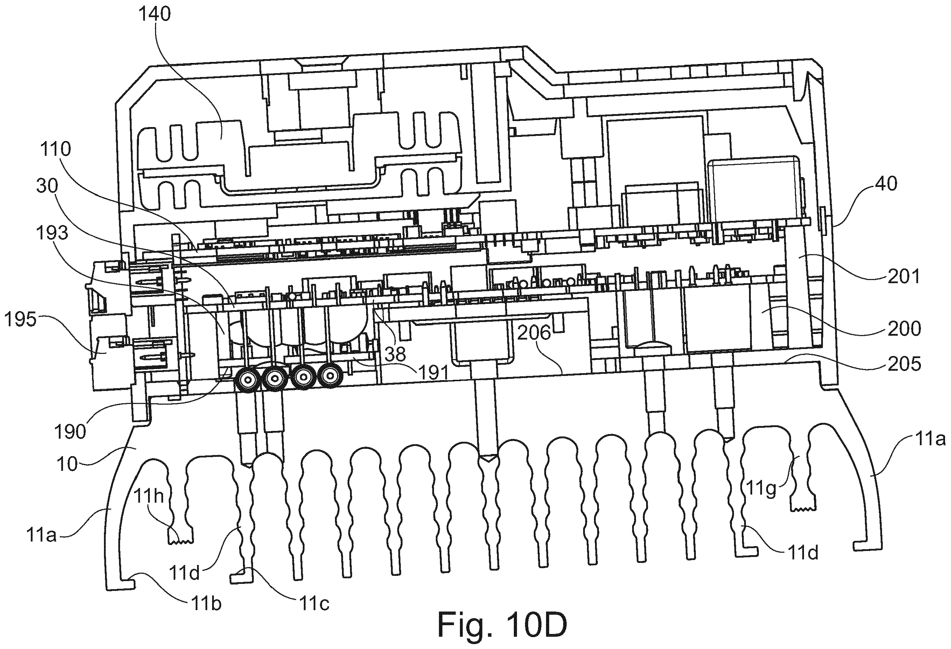

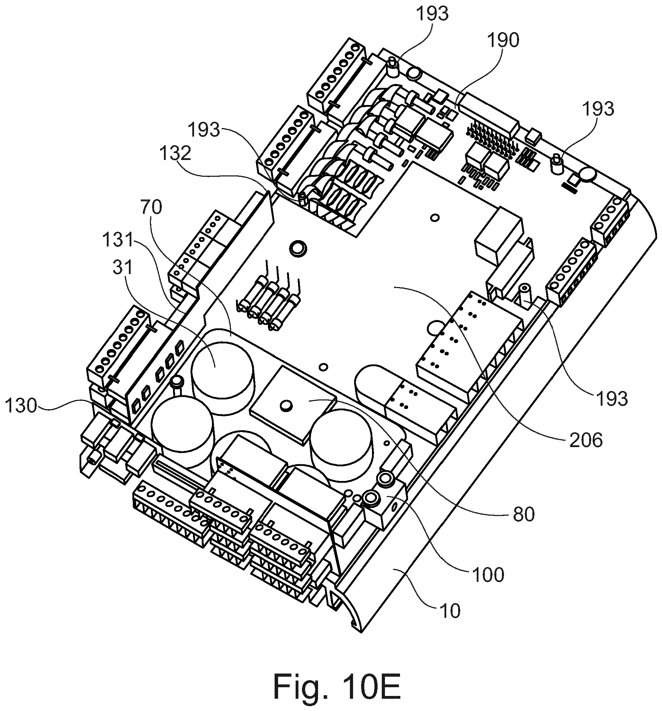

Comme on peut le voir sur les figures 10D et 10E, la carte 190 comporte une platine de circuit imprimé 191 qui s'étend parallèlement à la face intérieure du radiateur 10 entre ce dernier et la platine 38 de la carte de puissance 30. La platine 191 est fixée sur la platine 38 à l'aide d'entretoises 193.

On voit sur la figure 10D que la platine 38 repose sur des fûts de réception de vis 200 de la partie inférieure 40 et la platine 118 de la carte 110 sur des fûts 201. On voit également que la face intérieure 205 du boîtier 40 repose sur la face intérieure 206 du radiateur 10.

La platine 191 porte des connecteurs et/ou borniers 195.

### Reprise de masse

L'appareil 1 comporte une pièce 100 qui sert à la fixation d'une cosse reliée à la masse électrique et/ou à la terre. Cette pièce 100 est accessible latéralement grâce à une ouverture correspondante 45 réalisée sur la partie inférieure 40 de boîtier, et présente un trou taraudé 101 pour la fixation d'une vis de maintien de la cosse.

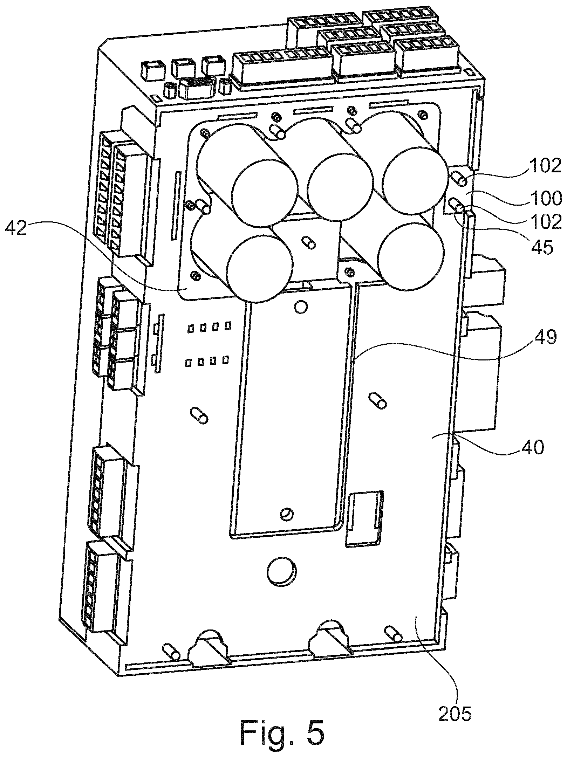

La pièce 100 est fixée sur le radiateur 10 par deux vis 102, visibles sur la figure 5. Ces vis 102 assurent un contact électrique entre le radiateur 10 et la pièce 100.

Les vis 102 présentent des têtes 104 qui s'appliquent sur des pistes conductrices correspondantes de la carte de puissance 30, de façon à relier électriquement ces pistes au radiateur 10 et à la cosse de masse et/ou de terre.

La pièce 100 joue ainsi une double fonction, à savoir d'une part assurer la connexion électrique entre le radiateur 10 et la carte de puissance 30 et un raccordement externe par cosse, et d'autre part une fixation mécanique de la carte de puissance 30 sur le radiateur 10. L'utilisation d'une pièce unique exerçant cette double fonction contribue à la compacité de l'appareil.

### Connecteur carte mémoire

La partie supérieure 50 de boîtier comporte, comme on peut le voir sur la figure 9 notamment, une ouverture 51 pour l'écran 121 et des trous 52 pour les boutons 122.

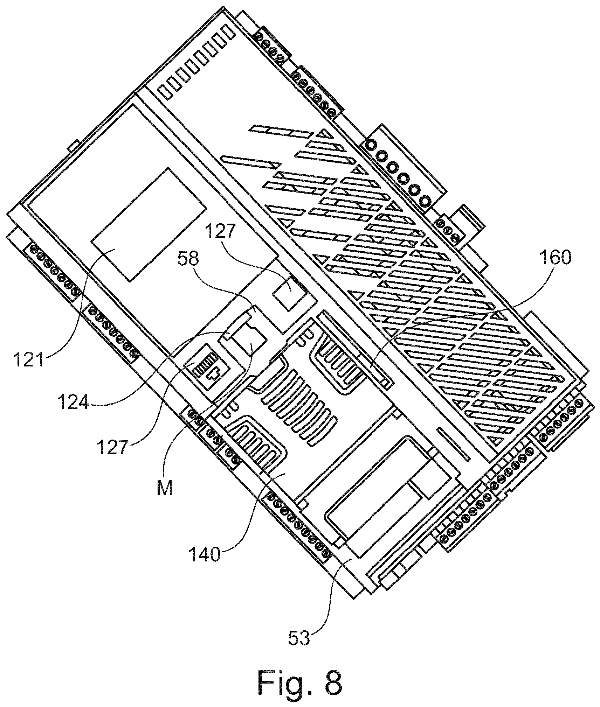

Un logement 53 est prévu pour recevoir un module complémentaire 140, visible sur la figure 8, pourvu d'un connecteur qui se raccorde à la carte de contrôle au travers d'une ouverture 56 débouchant dans le fond du logement 53.

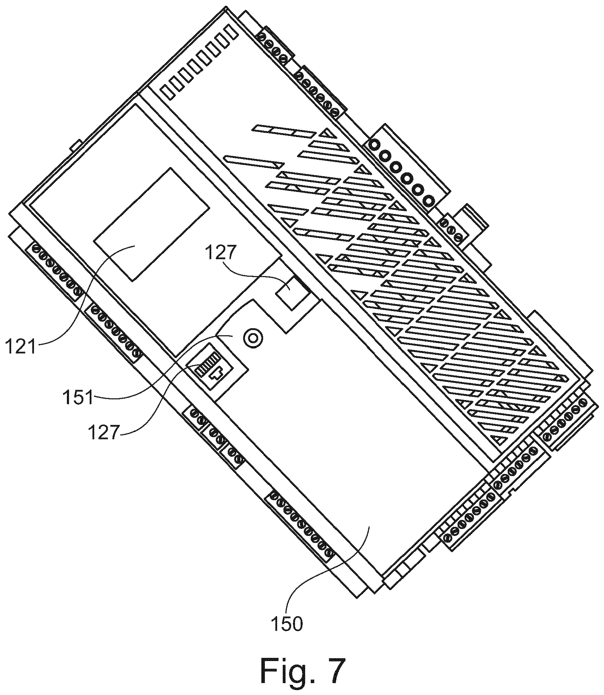

Le logement 53 est obturé par une trappe 150, visible sur la figure 7 notamment, qui est fixée sur la partie supérieure 50 par une patte 151 pourvue d'une vis qui s'engage dans un taraudage correspondant 57 prévu sur la partie supérieure 50.

Des moyens tels qu'une étiquette d'inviolabilité peuvent être disposés au niveau de la trappe 150 pour signaler l'enlèvement de celle-ci.

La carte d'interface HMI 120 porte un lecteur définissant un logement 124 de carte mémoire M par exemple du type « micro SD », qui débouche dans un renfoncement 58 de la partie supérieure 50 prévu pour accueillir la patte 151 de verrouillage de la trappe 150.

L'appareil 1 peut être configuré pour enregistrer dans la carte mémoire M différents paramètres de fonctionnement, et ainsi disposer d'un historique utile pour effectuer un diagnostic en cas de panne par exemple. La carte mémoire M peut encore être utile pour des opérations de mise à jour du firmware ou pour télécharger des paramètres spécifiques à l'application.

La carte d'interface HMI 120 peut porter également, comme on le voit sur la figure 10 notamment, un ou plusieurs connecteurs 127 de façade, par exemple de type RJ45 ou USB. La présence de ces connecteurs accessibles en façade facilite les opérations de mise à jour, de programmation et de diagnostic de l'appareil 1 par un opérateur.

Ces connecteurs 127 sont portés par des extensions 128 de la platine 129 de circuit imprimé de la carte 120, qui s'étendent de part et d'autre du renfoncement 58, contribuant ainsi à la compacité du montage de la carte 120 dans le boîtier de l'appareil 1.

L'appareil 1 peut comporter, comme on le voit sur la figure 10A, une pile de sauvegarde160 relié par un câble électrique 162 à la carte de contrôle 110. Cette pile de sauvegarde 160 est plate et orienté perpendiculairement à la carte de contrôle 110, étant logé dans un logement correspondant 161 ménagé dans la partie supérieure 50 de boîtier à côté du logement 53 recevant le module additionnel 140.

Ainsi, il est possible d'accéder à cette pile de sauvegarde 160 en enlevant la trappe 150, comme on peut le voir sur la figure 8, et la maintenance de l'appareil 1 s'en trouve facilitée.

### Redondance transistors de puissance

On a représenté à la figure 13 un demi-pont de puissance utilisé pour effectuer une régulation de type PWM lorsque l'appareil 1 est un régulateur d'alternateur, ce demi-pont étant relié par des bornes 230 et 232 à l'inducteur L de l'alternateur. On a également représenté de façon schématique sur cette figure un circuit de commande 240, appartenant par exemple à la carte de contrôle 110, et capable de générer un signal de commande 241.

Le demi-pont illustré à la figure 13 présente une redondance des composants de puissance pilotés, afin de s'assurer du contrôle et de la fourniture du courant d'excitation même en cas de défaillance d'un de ces composants, par exemple court-circuit d'un transistor ou blocage permanent du transistor.

Le demi-pont comporte une première paire TH1 et TH2 de transistors de puissance, reliés électriquement en parallèle entre la borne + du bus continu 310 et la borne 230 de l'inducteur L. Deux diodes de roue libre DL1 et DL2 sont reliées en parallèle entre la borne 230 de l'inducteur L et la borne - du bus continu. Les diodes DL1 et DL2 ont leur cathode reliée à la borne 230.

Le demi-pont comporte une deuxième paire TB1, TB2 de transistors de puissance reliés électriquement en parallèle entre la borne - du bus continu et la borne 232 de l'inducteur L. Deux diodes DF1 et DF2 sont disposés en parallèle entre la borne 232 et la borne + du bus continu, avec leur cathode reliée à cette borne + du bus.

Une surveillance est assurée par exemple par le circuit de commande 240, afin de vérifier que les transistors TH1, TH2, TB1, TB2 fonctionnent sans défaillance. Par exemple, la tension aux bornes de l'inducteur L est surveillée par l'appareil 1 pour vérifier qu'elle correspond bien à la commande PWM.

En fonctionnement normal, en l'absence de défaillance des transistors, le transistor TB1 est piloté en mode saturé permanent et TB2 est maintenu bloqué en attente. Seul le transistor TH1 reçoit le signal de commande 241, le transistor TH2 étant maintenu en attente bloqué.

Lorsque le transistor TH1 est piloté en conduction, le courant passe par ce transistor, par l'inducteur et par le transistor TB1. Au blocage du transistor TH1, le courant circulant dans l'inducteur circule en boucle dans le transistor TB1 et dans les diodes de roue libre DL1 et DL2.

En cas de « forcing » négatif, c'est-à-dire lorsque l'on a besoin de faire chuter rapidement le courant dans l'inducteur L afin d'améliorer la réponse en régulation de tension de l'alternateur sur un délestage de charge, le transistor TB1 est bloqué, et le courant circule à travers les diodes DL1, DL2 et DF1, DF2 et à travers les condensateurs du bus continu 310. Cela a pour effet d'inverser la tension aux bornes de l'inducteur L et de faire faire chuter plus rapidement le courant dans ce dernier.

Différentes situations de défaillance des transistors sont traitées par l'appareil 1.

### Casse de TH1 en court-circuit

La conséquence de cette défaillance est que ce transistor ne répond plus à la commande PWM, et le courant d'excitation monte rapidement dans l'inducteur.

Pour pallier au défaut, le transistor TH2 est piloté saturé pour maintenir le court-circuit en parallèle de TH1 et la commande PWM est envoyée sur TB1 ; TB2 est maintenu bloqué.

Seule la fonction de forcing négatif devient indisponible, ce qui constitue une perte acceptable de performance de fonctionnement.

### Casse de TH1 ouvert

Cette défaillance a pour effet que ce transistor ne répond plus à la commande PWM et le courant d'excitation chute rapidement.

Pour répondre à cette défaillance, le transistor TH1 est piloté bloqué afin d'éviter de potentielles commutations erratiques, et le transistor TH2 reçoit la commande PWM en remplacement de TH1. TB1 est maintenu à l'état saturé et TB2 à l'état bloqué.

On retrouve à nouveau un état normal de régulation du courant dans l'inducteur.

### Casse de TB1 en court-circuit

Le mode de fonctionnement normal de ce transistor étant le mode saturé, cette défaillance n'a pas de conséquence sur le courant d'excitation, excepté la perte de performance liée à l'impossibilité d'effectuer un forcing négatif.

Tant que le court-circuit est maintenu, il n'y a pas de correction à faire sur le pilotage pour ce qui est de la régulation du courant d'alternateur en fonctionnement normal.

### Casse de TB1ouvert

L'effet de cette défaillance est de faire chuter rapidement le courant dans l'inducteur, le transistor ne répondant plus à la commande le maintenant en saturation.

Pour remédier à cette défaillance, le transistor TB 1 est piloté bloqué pour éviter d'éventuelles commutations erratiques. Le transistor TB2 reçoit la commande saturée en remplacement de TB1. Le transistor TH1 continue à recevoir la commande PWM et le transistor TH2 est piloté bloqué.

On retrouve un état normal de contrôle du courant d'excitation.

Dans un exemple de mise en oeuvre de l'invention, les transistors TB1, TB2, TH1 et TH2 appartiennent à un module de puissance 90 monolithique, représenté à la figure 14, qui comporte sept transistors, étant commercialisé pour une autre application, ces transistors étant répartis en trois branches parallèles 301, 302, 303 comportant chacune deux transistors en série et un septième transistor en parallèle des trois branches, en série avec une diode 305.

On a identifié sur la figure 14 les transistors du module 90 qui peuvent être utilisés pour constituer les transistors TB1, TB2, TH1 et TH2.

Il s'agit des transistors du haut des branches 302, 301 pour les transistors TH1 et TH2, et du transistor du bas de la branche restante 303 pour le transistor TB1, le transistor TB2 étant constitué par le transistor qui est en série avec la diode 305.

L'invention n'est pas limitée à l'exemple qui vient d'être décrit. En particulier, on peut réaliser l'étage de puissance avec des composants discrets au lieu d'un module les regroupant.

## Revendications

1. Dispositif électronique, notamment régulateur d'alternateur, comportant un étage de puissance à relier à une charge inductive, notamment à un inducteur d'alternateur, comportant au moins une première paire de transistors de puissance (TH1, TH2) reliés à une borne (+) d'un bus continu, une deuxième paire de transistors (TB1, TB2), et un circuit de commande (240) de ces transistors, le dispositif étant **caractérisé en ce que** les transistors de la première paire de transistors (TH1, TH2) sont disposés en parallèle entre ladite borne (+) du bus continu et une première sortie (230) à relier à la charge (L), au moins une diode de roue libre (DL1, DL2) reliant la borne opposée (-) du bus continu à la première sortie (230), les transistors de la deuxième paire de transistors (TB1, TB2) sont reliés en parallèle entre une deuxième sortie (232) à relier à la charge (L) et la borne opposée (-) du bus continu, au moins une diode (DF1, DF2) reliant la deuxième sortie (232) à la borne (+) du bus continu, l'un (TB1) au moins des transistors de la deuxième paire étant piloté par le circuit de commande (240) de façon à être passant pendant le fonctionnement normal de l'appareil, le circuit de commande (240) est agencé pour générer un signal de commande pulsé permettant de réguler le courant dans la charge et pour détecter une défaillance de l'un des transistors, le circuit de commande étant agencé durant le fonctionnement normal, hors défaillance des transistors, pour envoyer le signal de commande (241) sur l'un (TH1) des transistors de la première paire tout en maintenant l'autre transistor (TH2) de cette paire dans un état bloqué, et le circuit de commande est agencé pour, en cas de défaillance d'un transistor (TH1) de la première paire (TH1, TH2) l'amenant à rester en court-circuit, piloter le second transistor (TH2) de cette paire pour le saturer, maintenir un transistor (TB2) de l'autre paire (TB1, TB2) à l'état bloqué et envoyer le signal de commande pulsé à l'autre transistor (TB1) de cette deuxième paire (TB1, TB2).

2. Dispositif selon la revendication 1, le circuit de commande étant agencé pour, en cas de défaillance d'un transistor (TH1) de la première paire l'amenant à rester en circuit ouvert, envoyer le signal de commande pulsé sur l'autre transistor (TH2) de cette paire.

3. Dispositif selon l'une quelconque des revendications précédentes, l'autre transistor (TB2) de la deuxième paire étant commandé par le circuit de commande (240) de façon à être bloqué pendant le fonctionnement normal.

4. Dispositif selon l'une des revendications précédentes, le circuit de commande étant agencé pour, en cas de défaillance de l'un (TB1) des transistors de la deuxième paire l'amenant à rester en circuit ouvert, piloter l'autre transistor (TB2) de cette paire pour le saturer.

5. Dispositif selon l'une quelconque des revendications 1 à 4, comportant deux diodes de roue libre (DL1, DL2) en parallèle.

6. Dispositif selon l'une quelconque des revendications 1 à 5, comportant deux diodes (DF1, DF2) en parallèle reliant la deuxième sortie (232) à la borne (+) du bus continu.

7. Dispositif selon l'une quelconque des revendications précédentes, étant agencé pour fonctionner en mode de forcing négatif lorsque le courant dans la charge doit être rapidement annulé pour les besoins de la régulation, mode dans lequel les transistors de la première paire (TH1, TH2) sont pilotés bloqués et les deux transistors de la deuxième paire (TB1, TB2) également.

8. Dispositif selon l'une quelconque des revendications 1 à 7, le signal de commande pulsé étant un signal de commande PWM (Pulse Width Modulation).

9. Dispositif selon l'une quelconque des revendications 1 à 8, les transistors de la première paire appartenant à un module de puissance (90) comprenant trois branches (301, 302, 303) en parallèle, chaque branche comprenant deux transistors en série, et un septième transistor en série avec une diode (304), l'ensemble formé par ce transistor en série avec la diode étant relié en parallèle avec les trois branches, les transistors (TH1 ; TH2) de la première paire étant pris chacun au sein d'une branche respective (302 ; 301).

10. Dispositif selon la revendication 9, l'un (TB1) des transistors de la deuxième paire étant choisi au sein de la branche restante (303) et l'autre transistor (TB2) étant constitué par le transistor qui est en série avec la diode (305).

11. Dispositif selon l'une quelconque des revendications 1 à 10, les transistors (TB1, TB2, TH1, TH2) étant des IGBT ou des MOSFET, de préférence des IGBT.

12. Procédé de régulation d'un alternateur dans lequel l'inducteur de l'alternateur est relié aux sorties d'un régulateur comportant :
- un étage de puissance comportant :
o une première paire de transistors de puissance (TH1, TH2) reliés en parallèle entre une borne (+) d'un bus continu et une première borne de l'inducteur,
∘ une deuxième paire de transistors (TB 1, TB2) reliés en parallèle entre une deuxième borne (232) de l'inducteur et une borne opposée (-) du bus continu,
∘ au moins une diode (DF1, DF2) reliant la deuxième borne (232) de l'inducteur à la borne (+) du bus continu,
∘ au moins une diode de roue libre (DL1, DL2) reliant la borne opposée (-) du bus continu à la première borne (230) de l'inducteur (L),
- un circuit de commande (240) agencé pour générer un signal de commande pulsé permettant de réguler le courant dans l'inducteur et pour détecter une défaillance de l'un des transistors,
procédé dans lequel :
- durant le fonctionnement normal du régulateur, l'un (TB 1) au moins des transistors de la deuxième paire est piloté par le circuit de commande (240) de façon à être passant, le signal de commande (241) est envoyé sur l'un (TH1) des transistors de la première paire tout en maintenant l'autre transistor (TH2) de cette paire dans un état bloqué,
- en cas de demande d'annulation rapide du courant dans l'inducteur pour les besoins de la régulation, les transistors de la première paire (TH1, TH2) et les transistors de la deuxième paire (TB1, TB2) sont pilotés bloqués,
- en cas de défaillance d'un transistor (TH1) de la première paire l'amenant à rester en circuit ouvert, on envoie pour les besoins de la régulation du courant dans l'inducteur le signal de commande pulsé sur l'autre transistor (TH2) de cette paire,
- en cas de défaillance de l'un (TB1) des transistors de la deuxième paire l'amenant à rester en circuit ouvert, on pilote l'autre transistor (TB2) de cette paire pour le saturer,
- en cas de défaillance d'un transistor (TH1) de la première paire (TH1, TH2) l'amenant à rester en court-circuit, on pilote le second transistor (TH2) de cette paire pour le saturer, on maintient un transistor (TB2) de l'autre paire (TB1, TB2) à l'état bloqué et on envoie le signal de commande pulsé à l'autre transistor (TB1) de cette deuxième paire (TB1, TB2) pour les besoins de régulation du courant dans l'inducteur.

## Patentansprüche

1. Elektronische Vorrichtung, insbesondere Generatorregler, aufweisend eine Leistungsstufe zur Verbindung mit einer induktiven Last, insbesondere mit einem Generatorinduktor, mit wenigstens einem ersten Paar Leistungstransistoren (TH1, TH2), die mit einer Klemme (+) eines Gleichstrombusses verbunden sind, einem zweiten Paar Transistoren (TB1, TB2) und einer Steuerschaltung (240) für diese Transistoren, die Transistoren des ersten Transistorenpaars (TH1, TH2) sind parallel zwischen der Klemme (+) des Gleichstrombusses und einem ersten Ausgang (230) angeordnet, der mit der Last (L) zu verbinden ist, wobei wenigstens eine Freilaufdiode (DL1, DL2) die entgegengesetzte Klemme (-) des Gleichstrombusses mit dem ersten Ausgang (230) verbindet, die Transistoren des zweiten Transistorenpaars (TB1, TB2) sind parallel zwischen einen zweiten Ausgang (232) zur Verbindung mit der Last (L) und die entgegengesetzte Klemme (-) des Gleichstrombusses geschaltet, wobei wenigstens eine Diode (DF1, DF2) den zweiten Ausgang (232) mit der Klemme (+) des Gleichstrombusses verbindet, wobei wenigstens einer (TB1) der Transistoren des zweiten Paars so von der Steuerschaltung (240) angesteuert wird, dass er während des Normalbetriebs des Geräts durchlässig ist, die Steuerschaltung (240) ist dafür angeordnet, ein gepulstes Steuersignal zu erzeugen, mit dem der Strom in der Last geregelt werden kann, und einen Ausfall eines der Transistoren zu detektieren, wobei die Steuerschaltung während des Normalbetriebs ohne Ausfall der Transistoren dafür angeordnet ist, das Steuersignal (241) an einen (TH1) der Transistoren des ersten Paars zu senden, wobei sie den anderen Transistor (TH2) dieses Paars in einem gesperrten Zustand hält, **dadurch gekennzeichnet, dass** die Steuerschaltung dafür angeordnet ist, im Falle eines Ausfalls eines Transistors (TH1) des ersten Paars (TH1, TH2), wodurch er kurzgeschlossen bleibt, den zweiten Transistor (TH2) dieses Paars anzusteuern, um ihn zu sättigen, einen Transistor (TB2) des anderen Paars (TB1, TB2) im gesperrten Zustand zu halten und das gepulste Steuersignal an den anderen Transistor (TB1) dieses zweiten Paars (TB1, TB2) zu senden.

2. Vorrichtung nach Anspruch 1, wobei die Steuerschaltung dafür angeordnet ist, im Falle eines Ausfalls eines Transistors (TH1) des ersten Paars, wodurch er im Leerlauf bleibt, das gepulste Steuersignal an den anderen Transistor (TH2) dieses Paars zu senden.

3. Vorrichtung nach einem der vorhergehenden Ansprüche, wobei der andere Transistor (TB2) des zweiten Paars so von der Steuerschaltung (240) gesteuert wird, dass er während des Normalbetriebs gesperrt ist.

4. Vorrichtung nach einem der vorhergehenden Ansprüche, wobei die Steuerschaltung dafür angeordnet ist, im Falle eines Ausfalls eines (TB1) der Transistoren des zweiten Paars, wodurch er im Leerlauf bleibt, den anderen Transistor (TB2) dieses Paars anzusteuern, um ihn zu sättigen.

5. Vorrichtung nach einem der Ansprüche 1 bis 4, aufweisend zwei parallele Freilaufdioden (DL1, DL2).

6. Vorrichtung nach einem der Ansprüche 1 bis 5, aufweisend zwei parallele Dioden (DF1, DF2), die den zweiten Ausgang (232) mit der Klemme (+) des Gleichstrombusses verbinden.

7. Vorrichtung nach einem der vorhergehenden Ansprüche, die dafür angeordnet ist, im Negativ-Forcing-Modus zu arbeiten, wenn der Strom in der Last zu Regelungszwecken schnell aufgehoben werden muss, wobei in diesem Modus die Transistoren des ersten Paars (TH1, TH2) gesperrt angesteuert werden und die zwei Transistoren des zweiten Paars (TB1, TB2) ebenfalls.

8. Vorrichtung nach einem der Ansprüche 1 bis 7, wobei das gepulste Steuersignal ein PWM- (Pulse Width Modulation) Signal ist.

9. Vorrichtung nach einem der Ansprüche 1 bis 8, wobei die Transistoren des ersten Paars zu einem Leistungsmodul (90) gehören, das drei parallele Zweige (301, 302, 303), wobei jeder Zweig zwei Transistoren in Reihe umfasst, und einen siebten Transistor in Reihe mit einer Diode (304) umfasst, wobei die Anordnung, die von diesem Transistor in Reihe mit der Diode gebildet ist, mit den drei Zweigen parallel geschaltet ist, wobei die Transistoren (TH1; TH2) des ersten Paars jeweils innerhalb eines jeweiligen Zweigs (302; 301) aufgenommen sind.

10. Vorrichtung nach Anspruch 9, wobei einer (TB1) der Transistoren des zweiten Paars aus dem verbleibenden Zweig (303) gewählt ist und der andere Transistor (TB2) von dem Transistor gebildet ist, der sich in Reihe mit der Diode (305) befindet.

11. Vorrichtung nach einem der Ansprüche 1 bis 10, wobei die Transistoren (TB1, TB2, TH1, TH2) IGBTs oder MOSFETs, vorzugsweise IGBTs sind.

12. Verfahren zur Regelung eines Generators, wobei der Induktor des Generators mit den Ausgängen einer Reglers verbunden ist, der Folgendes aufweist:
- eine Leistungsstufe mit:
o einem ersten Paar Leistungstransistoren (TH1, TH2), die zwischen einer Klemme (+) eines Gleichstrombusses und einer ersten Klemme des Induktors parallel geschaltet sind,
o einem zweiten Paar Transistoren (TB1, TB2), die zwischen einer zweiten Klemme (232) des Induktors und einer entgegengesetzten Klemme (-) des Gleichstrombusses parallel geschaltet sind,
o wenigstens einer Diode (DF1, DF2), die die zweite Klemme (232) des Induktors mit der Klemme (+) des Gleichstrombusses verbindet,
o wenigstens einer Freilaufdiode (DL1, DL2), die die entgegengesetzte Klemme (-) des Gleichstrombusses mit der ersten Klemme (230) des Induktors (L) verbindet,
- eine Steuerschaltung (240), die dafür angeordnet ist, ein gepulstes Steuersignal zu erzeugen, mit dem der Strom im Induktor geregelt werden kann, und einen Ausfall eines der Transistoren zu detektieren,
wobei bei dem Verfahren:
- während des Normalbetriebs des Reglers wenigstens einer (TB1) der Transistoren des zweiten Paars so von der Steuerschaltung (240) angesteuert wird, dass er durchlässig ist, das Steuersignal (241) an einen (TH1) der Transistoren des ersten Paars gesendet wird, wobei der andere Transistor (TH2) dieses Paars in einem gesperrten Zustand gehalten wird,
- bei Anforderung einer schnellen Aufhebung des Stroms im Induktor zu Regelungszwecken die Transistoren des ersten Paars (TH1, TH2) und die Transistoren des zweiten Paars (TB1, TB2) gesperrt angesteuert werden,
- im Falle eines Ausfalls eines Transistors (TH1) des ersten Paars, wodurch er im Leerlauf bleibt, zu Zwecken der Regelung des Stroms im Induktor das gepulste Steuersignal an den anderen Transistor (TH2) dieses Paars gesendet wird,
- im Falle eines Ausfalls eines (TB1) der Transistoren des zweiten Paars, wodurch er im Leerlauf bleibt, der andere Transistor (TB2) dieses Paars angesteuert wird, um ihn zu sättigen, **dadurch gekennzeichnet, dass**
- im Falle eines Ausfalls eines Transistors (TH1) des ersten Paars (TH1, TH2), wodurch er kurzgeschlossen bleibt, der zweite Transistor (TH2) dieses Paars angesteuert wird, um ihn zu sättigen, ein Transistor (TB2) des anderen Paars (TB1, TB2) im gesperrten Zustand gehalten wird und das gepulste Steuersignal zu Zwecken der Regelung des Stroms im Induktor an den anderen Transistor (TB1) dieses zweiten Paars (TB1, TB2) gesendet wird.

## Claims

1. Electronic device, in particular an alternator regulator, comprising a power stage to be connected to an inductive load, in particular to an alternator inductor, comprising at least one first pair of power transistors (TH1, TH2) connected to a (+) terminal of a DC bus, a second pair of transistors (TB1, TB2) and a control circuit (240) for said transistors, the transistors of the first pair of transistors (TH1, TH2) being disposed in parallel between said (+) terminal of the DC bus and a first output (230) to be connected to the load (L), at least one flyback diode (DL1, DL2) connecting the opposite (-) terminal of the DC bus to the first output (230), the transistors of the second pair of transistors (TB1, TB2) being connected in parallel between a second output (232) to be connected to the load (L) and the opposite (-) terminal of the DC bus, at least one diode (DF1, DF2) connecting the second output (232) to the (+) terminal of the DC bus, at least one (TB1) of the transistors of the second pair being controlled by the control circuit (240) so as to be in an on-state during normal operation of the device, the control circuit (240) being designed to generate a pulsed control signal for regulating the current in the load and for detecting a failure of one of the transistors, the control circuit being designed, during normal operation, in the absence of a failure of the transistors, to send the control signal (241) to one (TH1) of the transistors of the first pair, while maintaining the other transistor (TH2) of said pair in an off-state, **characterized in that** the control circuit is designed, in the event of the failure of one transistor (TH1) of the first pair (TH1, TH2) causing it to remain in an open circuit, to control the second transistor (TH2) of said pair in order to saturate said transistor, to maintain a transistor (TB2) of the other pair (TB1, TB2) in the off-state and to send the pulsed control signal to the other transistor (TB1) of said second pair (TB1, TB2).

2. Device according to Claim 1, the control circuit being designed, in the event of the failure of one transistor (TH1) of the first pair causing it to remain in an open circuit, to send the pulsed control signal to the other transistor (TH2) of said pair.

3. Device according to either one of the preceding claims, the other transistor (TB2) of the second pair being controlled by the control circuit (240) in order to be in an off-state during normal operation.

4. Device according to one of the preceding claims, the control circuit being designed, in the event of the failure of one (TB1) of the transistors of the second pair causing it to remain in an open circuit, to control the other transistor (TB2) of said pair in order to saturate said transistor.

5. Device according to any one of Claims 1 to 4, comprising two flyback diodes (DL1, DL2) in parallel.

6. Device according to any one of Claims 1 to 5, comprising two diodes (DF1, DF2) in parallel connecting the second output (232) to the (+) terminal of the DC bus.

7. Device according to any one of the preceding claims, being designed to operate in negative forcing mode when the current in the load has to be rapidly cancelled for the purposes of the regulation, in which mode the transistors of the first pair (TH1, TH2) are controlled in the off-state, as are the two transistors of the second pair (TB1, TB2).

8. Device according to any one of Claims 1 to 7, the pulsed control signal being a PWM (Pulse Width Modulation) control signal.

9. Device according to any one of Claims 1 to 8, the transistors of the first pair belonging to a power module (90) comprising three branches (301, 302, 303) in parallel, each branch comprising two transistors in series, and a seventh transistor in series with a diode (304), the assembly formed by this transistor in series with the diode being connected in parallel with the three branches, the transistors (TH1; TH2) of the first pair each being held within a respective branch (302; 301).

10. Device according to Claim 9, one (TB1) of the transistors of the second pair being held within the remaining branch (303) and the other transistor (TB2) being formed by the transistor that is in series with the diode (305).

11. Device according to any one of Claims 1 to 10, the transistors (TB1, TB2, TH1, TH2) being IGBTs or MOSFETs, preferably IGBTs.

12. Method for regulating an alternator, in which the inductor of the alternator is connected to the outputs of a regulator comprising:
- a power stage comprising:
∘ a first pair of power transistors (TH1, TH2) connected in parallel between a (+) terminal of a DC bus and a first terminal of the inductor;
∘ a second pair of transistors (TB1, TB2) connected in parallel between a second terminal (232) of the inductor and an opposite (-) terminal of the DC bus;
∘ at least one diode (DF1, DF2) connecting the second terminal (232) of the inductor to the (+) terminal of the DC bus;
∘ at least one flyback diode (DL1, DL2) connecting the opposite (-) terminal of the DC bus to the first terminal (230) of the inductor (L);
- a control circuit (240) designed to generate a pulsed control signal for regulating the current in the inductor and for detecting a failure of one of the transistors,
in which method:
- during normal operation of the regulator, at least one (TB1) of the transistors of the second pair is controlled by the control circuit (240) so as to be in the on-state, the control signal (241) is sent to one (TH1) of the transistors of the first pair, while maintaining the other transistor (TH2) of said pair in an off-state;
- in the event of a request for rapid cancellation of the current in the inductor for the purposes of the regulation, the transistors of the first pair (TH1, TH2) and the transistors of the second pair (TB1, TB2) are controlled in the off-state;
- in the event of the failure of a transistor (TH1) of the first pair causing it to remain in an open circuit, the pulsed control signal is sent to the other transistor (TH2) of said pair for the purposes of regulating the current in the inductor;
- in the event of the failure of one (TB1) of the transistors of the second pair causing it to remain in an open circuit, the other transistor (TB2) of said pair is controlled in order to saturate said transistor, **characterized in that**
- in the event of the failure of a transistor (TH1) of the first pair (TH1, TH2) causing it to remain in an open circuit, the second transistor (TH2) of said pair is controlled in order to saturate said transistor, a transistor (TB2) of the other pair (TB1, TB2) is maintained in the off-state and the pulsed control signal is sent to the other transistor (TB1) of said second pair (TB1, TB2) for the purposes of regulating the current in the inductor.
